# EUROPEAN PATENT SPECIFICATION

(11) **EP 3 331 123 B1**
(45) Date of publication and mention of the grant of the patent: **30.12.2020**
(21) Application number: 17163569.1
(22) Date of filing: 29.03.2017
(51) Int. Cl.: H02J 7/00, G06F 1/24

(54) **ELECTRONIC APPARATUS AND POWER SUPPLY CIRCUIT THEREOF**
ELEKTRONISCHE VORRICHTUNG UND STROMVERSORGUNGSKREIS DAFÜR
APPAREIL ÉLECTRONIQUE ET SON CIRCUIT D'ALIMENTATION ÉLECTRIQUE

(30) Priority: 05.12.2016 CN 201621321465 U
(43) Date of publication of application: 06.06.2018
(73) Proprietor: Cal-Comp Big Data, Inc., New Taipei City 22201 (TW)
(72) Inventor: LIN, Min-Hsin, New Taipei City 22201 (TW)
(74) Representative: 2K Patentanwälte Blasberg Kewitz & Reichel

(56) References cited:
- EP-A2- 1 282 071
- JP-A- H09 274 523
- US-A1- 2016 087 480

## Description

### CROSS-REFERENCE TO RELATED APPLICATION

This application claims the priority benefit of Chinese application serial no. 201621321465.8, filed on December 5, 2016.

### BACKGROUND OF THE INVENTION

### [Field of the Invention]

The invention relates to a power supply technique, and in particular, a power supply circuit having a reset function and an electronic apparatus including the power supply circuit.

### [Description of Related Art]

Nowadays, electronic apparatuses emphasize multitasking and are thus frequently required to execute a plurality of functions at the same time. When the multitasking of an electronic apparatus exceeds its workload, the electronic apparatus is likely to slow down in its operations, fail to function normally, or have other issues, which finally result in breakdown of the electronic apparatus. When the electronic apparatus breaks down, if the electronic apparatus is not equipped with a watch dog timer and a self-resetting function, the electronic apparatus cannot re-start on its own. Furthermore, if the electronic apparatus is built-in with a rechargeable battery and only a power input port is provided without a physical reset button or power switch button, with the built-in rechargeable battery having power and constantly supplying power to the electronic apparatus, a user cannot reset the electronic apparatus since the electronic apparatus does not include a reset button or a power switch button. In that case, the electronic apparatus will remain in a breakdown state and cannot be used.

US 2016/087480 A1 discloses a rechargeable computing device including a battery, a processor, a power receiver, a reset switch, and a circuit for receiving a reset signal may receive the reset signal via a power source. The processor may be configured to be reset in response to actuation of the reset switch. The power receiver may be configured to receive a wireless power transmission from a remote charging apparatus and charge the battery using power captured from the wireless power transmission. The reset switch may be coupled to the processor and to the circuit for receiving a reset signal. The circuit for receiving a reset signal may be configured to activate the reset switch to reset the processor in response to detecting a reset signal encoded within a wireless power transmission. In some embodiments, the circuit for receiving a reset signal may be configured to receive the signal from a wired power input.

JP H09 274523 A discloses a reset device with which a reset signal satisfying pulse width to be recognized as the reset signal can be outputted corresponding to a reset factor to occur at short intervals. When a reset element 1 detects the generation of the reset factor such as fluctuation in a power supply voltage or a request from the outside, a flip-flop 5 inverts a pulse as the reset signal. Then, when the cancel of the reset factor is detected, a counter 3 measures the time of pulse width to be recognized as the reset signal. At the time point when the measurement of time is finished by the counter 3, the flip-flop 5 inverts the pulse as the reset signal again.

EP 1 282 071 A2 discloses a power-on reset circuit (18) including a first reset circuit (21), a second reset circuit (22), and an NOR circuit (23). The first reset circuit detects VCC2V supplied to a logic section (IB) so as to produce a first reset signal RST1, and the second reset circuit detects REGIN voltage, which is an output voltage of a rectifying circuit (14) that rectifies power voltage obtained from an external power supply source, so as to produce a second reset signal RST2. The NOR circuit outputs either the RST1 or the RST2 as a reset signal P-RST. The above arrangement can provide the power-on reset circuit which outputs a reliable and effective reset signal even in case where the rising of power obtained from the external power supply source varies.

### SUMMARY OF THE INVENTION

To solve the problem above, the invention provides an electronic apparatus according to claim 9 and a power supply circuit according to claim 1. Further embodiments are provided in the dependent claims.

Hence, the power supply circuit of the electronic apparatus provided in the embodiments of the invention is capable of disabling the output voltage signal for a predetermined time period in response to the start of supply of the input power (or in response to the power-on transition from the input power being unavailable to the input power being available), such that the electronic apparatus body could be reset in response to the disable state of the output voltage signal. Accordingly, in the case where an electronic apparatus is not provided with a physical power switch button or a physical reset button, even if the electronic apparatus breaks down or needs to be re-started with the built-in battery still having power, the power supply circuit can reset the electronic apparatus once the input power is re-provided to the electronic apparatus.

To provide a further understanding of the aforementioned and other features and advantages of the invention, exemplary embodiments, together with the reference drawings, are described in detail below.

### BRIEF DESCRIPTION OF THE DRAWINGS

The drawings attached below form a part of the specification of the invention and illustrate the exemplary embodiments of the invention. The attached drawings and the description in the specification together illustrate the principles of the invention.
FIG. 1 is a block schematic diagram illustrating an electronic apparatus according to one embodiment of the invention.
FIG. 2 is a block schematic diagram illustrating a power supply circuit according to one embodiment of the invention.
FIG. 3 is a schematic diagram illustrating signal waveforms of the power supply circuit of FIG. 2.
FIG. 4 is a schematic diagram illustrating a circuit framework of a reset circuit according to one embodiment of the invention.

### DESCRIPTION OF THE EMBODIMENTS

To provide a further understanding of the content of the invention, embodiments are provided as examples below for the invention to be implemented accordingly. In addition, wherever applicable, elements/components marked with the same reference numerals in the drawings and the embodiments refer to the same or similar parts.

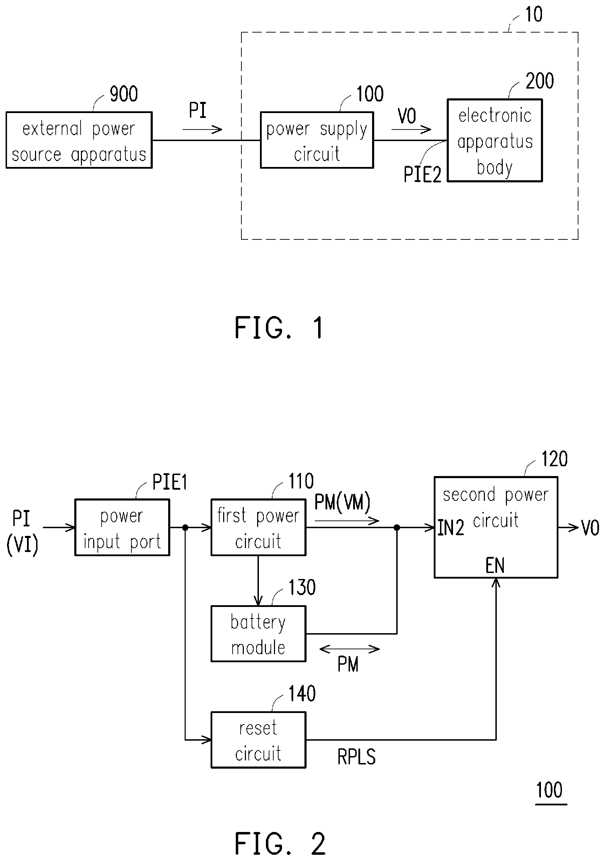

Referring to FIG. 1, FIG. 1 is a block schematic diagram illustrating an electronic apparatus 10 according to one embodiment of the invention. The electronic apparatus 10 may be any electronic apparatus that is not provided with a physical power button or reset button, and the invention does not limit the type of the electronic apparatus 10. The electronic apparatus 10 includes a power supply circuit 100 and an electronic apparatus body 200. For example, if the electronic apparatus 10 is a body fat measuring apparatus, the electronic apparatus body 200 is a main circuit for measuring body fat.

The power supply circuit 100 is configured to receive an input power PI from an external power source apparatus 900 and convert the input power PI to generate an output voltage signal VO. Alternatively, when the input power PI is zero, the power supply circuit 100 may output its stored power to provide the output voltage signal VO. The power supply circuit 100 is coupled to a power input end PIE2 of the electronic apparatus body 200 and provides the output voltage signal VO to the power input end PIE2 of the electronic apparatus body 200 to supply power to the electronic apparatus body 200. Specifically, the power supply circuit 100 may disable the output voltage signal VO for a predetermined time period in response to a start of supply of the input power PI (or in response to the power-on transition from the input power being unavailable to the input power being available), such that the electronic apparatus body 200 can be reset in response to a disable state of the output voltage signal VO.

For example, in a case where the external power source apparatus 900 is providing the input power PI to the power supply circuit 100, once the electronic apparatus body 200 cannot function normally due to a breakdown for some reason, as long as the external power source apparatus 900 first stops power supply and the external power source apparatus 900 then re-provides the input power PI to the power supply circuit 100, the power supply circuit 100 can provide the output voltage signal VO in the disable state for a predetermined time period to the electronic apparatus body 200, such that the electronic apparatus body 200 could be reset. Alternatively, in a case where the external power source apparatus 900 does not provide the input power PI to the power supply circuit 100, once the electronic apparatus body 200 cannot function normally due to a breakdown for some reason, as long as the external power source apparatus 900 re-provides the input power PI to the power supply circuit 100, the power supply circuit 100 can provide the output voltage signal VO in the disable state for a predetermined time period to the electronic apparatus body 200, such that the electronic apparatus body 200 could be reset.

In one embodiment of the invention, the external power source apparatus 900 could be an adapter plugged to the power supply circuit 100 to supply the input power PI to the power supply circuit 100. Accordingly, through a plugging operation between the external power source apparatus 900 and the power supply circuit 100, the electronic apparatus body 200 could be reset. However, the invention is not limited hereto.

In another embodiment of the invention, the external power source apparatus 900 could be a mobile power apparatus that includes a power supply switch and is coupled to the power supply circuit 100 to supply the input power PI to the power supply circuit 100. Accordingly, through a switching operation on the power supply switch of the mobile power apparatus, the electronic apparatus body 200 could be reset. However, the invention is not limited hereto.

Referring to FIG. 1 and FIG. 2 together, FIG. 2 is a block schematic diagram illustrating the power supply circuit 100 according to one embodiment of the invention. The power supply circuit 100 includes a power input port PIE1, a first power circuit 110, a second power circuit 120, a battery module 130, and a reset circuit 140. The power input port PIE1 is configured to receive an input power PI from an external power source apparatus 900. The first power circuit 110 is coupled to the power input port PIE1 and the battery module 130. The first power circuit 110 is configured to convert the input power PI and accordingly output a first power PM to the second power circuit 120 and the battery module 130. The first power circuit 110 charges the battery module 130 with the first power PM.

The reset circuit 140 is coupled to the power input port PIE1 to generate a reset pulse signal RPLS in response to a start of supply of the input power PI. An input end IN2 of the second power circuit 120 receives the first power PM and an enable end EN of the second power circuit 120 is coupled to the reset circuit 140 to receive the reset pulse signal RPLS. When the input power PI is not provided by the external power source apparatus (namely, when the input power PI is zero or unavailable), the first power circuit 110 controls the battery module 130 to supply power such that the battery module 130 provides the first power PM to the second power circuit 120. The second power circuit 120 converts the received first power PM to generate an output voltage signal VO and disables the output voltage signal VO in response to the reset pulse signal RPLS.

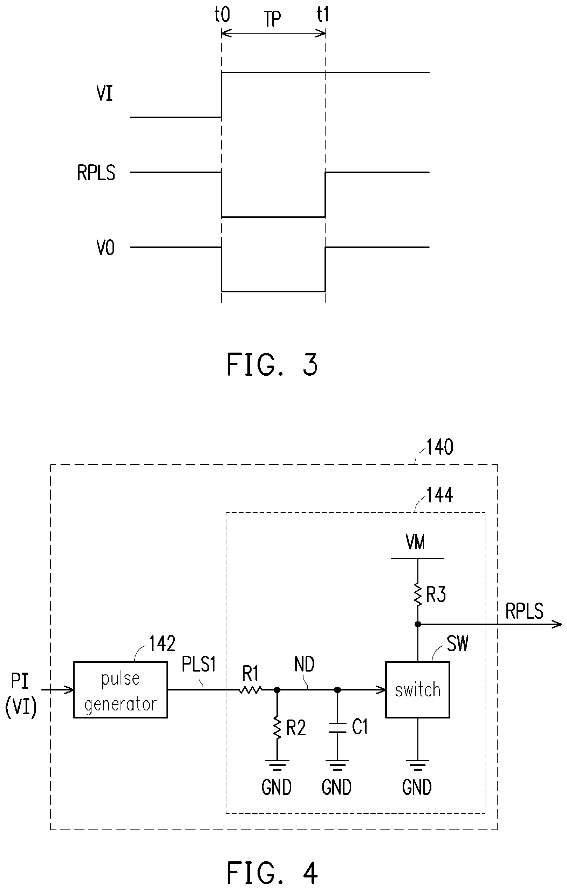

Referring to FIG. 1 to FIG. 3 together, FIG. 3 is a schematic diagram illustrating signal waveforms of the power supply circuit 100 of FIG. 2. For ease of illustration, it is supposed here that a voltage VI of the input power PI is 5V, a voltage VM of the first power PM is 3.0-4.25V, a logic high level of the output voltage signal VO is 3.0-3.3V, the battery module 130 is in a state of having power, and the reset pulse signal RPLS is set at the logic high level (3.0-4.25V) by default to configure the second power circuit 120 in an enable state.

As illustrated in FIG. 3, before a time point t0, the input power PI is zero. Therefore, the battery module 130 provides the first power PM (the voltage VM is 3.0-4.25V) to the second power circuit 120. The second power circuit 120 converts the first power PM provided by the battery module 130 to generate the output voltage signal VO (which is at the logic high level of 3.0-3.3V).

Next, at the time point t0, the external power source apparatus 900 is plugged to the power supply circuit 100 to start supplying the input power PI to the power supply circuit 100. Therefore, the voltage VI received by the power supply circuit 100 rises from 0V to 5V. At this time, the first power circuit 110 converts the input power PI and accordingly outputs the first power PM to charge the battery module 130. In response to the start of supply of the input power PI, the reset circuit 140 generates the reset pulse signal RPLS at a logic low level (0V) to disable the second power circuit 120, which causes the output voltage signal VO to be pulled down from the logic high level (3.0-3.3V) to the logic low level (0V) and thereby resets the electronic apparatus body 200.

After a predetermined time period TP, as shown by a time point t1, the reset circuit 140 provides the reset pulse signal RPLS at the logic high level (3.0-4.25V) to re-enable the second power circuit 120, which causes the output voltage signal VO to be pulled up from the logic low level (0V) to the logic high level (3.0-3.3V) so as to re-supply power to the electronic apparatus body 200.

It shall be mentioned that the relationship between the logic high/low levels of the reset pulse signal RPLS and the enablement of the second power circuit 120 as described in the embodiment above is only an example. People of ordinary skill in the art are all aware that the relationship between the logic high/low levels of the reset pulse signal RPLS and the enablement of the second power circuit 120 may be defined by designers according to the actual needs.

In one embodiment of the invention, a pulse width of the reset pulse signal RPLS illustrated in FIG. 3 (i.e., a time period between the time points t0 and t1) is between 140 ms and 560 ms. However, the invention is not limited hereto and is determined according to the actual application or the design needs of the electronic apparatus body 200.

In one embodiment of the invention, the first power circuit 110 is a battery charger IC. The battery charger IC could be a known battery charging circuit, which may be implemented by (but not limited to) the BQ24092 chip of Texas Instruments (TI), for example, and is thus not repeatedly described here.

In one embodiment of the invention, the second power circuit 120 could be a low dropout regulator (LDO). The low dropout regulator could be a known voltage regulator circuit and is thus not repeatedly described here.

In one embodiment of the invention, the battery module 130 may represent a single battery (or battery component), a battery combination, or a module including one or more batteries (or battery components). Moreover, the battery module 130 may be a rechargeable battery such as a nickel-zinc battery, a nickel-hydrogen battery, a lithium ion battery, a lithium polymer battery, or a lithium iron phosphate battery but is not limited hereto.

In one embodiment of the invention, the reset circuit 140 could be implemented by a digital count circuit. More specifically, the reset circuit 140 could be triggered to start counting at a rising edge of the voltage VI of the input power PI, and stops counting after a count reaches the predetermined time period TP to accordingly generate the reset pulse signal RPLS. Specifically, the digital count circuit could be any known counter and is thus not repeatedly described here.

Referring to FIG. 2 and FIG. 4 together, FIG. 4 is a schematic diagram illustrating a circuit framework of the reset circuit 140 according to another embodiment of the invention. The reset circuit 140 includes a pulse generator 142 and a pulse width modulation circuit 144. An input end of the pulse generator 142 is coupled to the power input port PIE1 to receive the input power PI and accordingly generate a first pulse signal PLS1. The pulse width modulation circuit 144 is coupled to an output end of the pulse generator 142 to receive the first pulse signal PLS1 and modulates a pulse width of the first pulse signal PLS1 to generate a reset pulse signal RPLS.

In one embodiment of the invention, the pulse width modulation circuit 144 could be implemented by an analog circuit. As illustrated in FIG. 4, the pulse width modulation circuit 140 includes a first resistor R1, a second resistor R2, a third resistor R3, a capacitor C1, and a switch SW. The first resistor R1 is coupled between the output end of the pulse generator 142 and a node ND. The second resistor R2 is coupled between the node ND and a grounding end GND. The capacitor C1 is coupled between the node ND and the grounding end GND. A first end of the switch SW is coupled to the grounding end GND. A control end of the switch SW is coupled to the node ND. A second end of the switch SW is configured to generate a reset pulse signal RPLS. A first end of the third resistor R3 receives the voltage VM of the first power PM. A second end of the third resistor R3 is coupled to the second end of the switch SW.

In one embodiment of the invention, the switch SW could be an NPN bipolar junction transistor, wherein the first end of the switch SW is an emitter end of the NPN bipolar junction transistor, the second end of the switch SW is a collector end of the NPN bipolar junction transistor, and the control end of the switch SW is a base end of the NPN bipolar junction transistor.

In another embodiment of the invention, the switch SW could be an N-type metal-oxide-semiconductor field-effect transistor, wherein the first end of the switch SW is a source end of the N-type metal-oxide-semiconductor field-effect transistor, the second end of the switch SW is a drain end of the N-type metal-oxide-semiconductor field-effect transistor, and the control end of the switch SW is a gate end of the N-type metal-oxide-semiconductor field-effect transistor.

The implementations of the switch SW mentioned in the foregoing embodiments are merely examples and do not meant to limit the invention. The type of the switch SW shall be determined by the actual application or the design needs.

The operation of the reset circuit 140 of FIG. 4 is described below. Referring to FIG. 3 and FIG. 4 together, before the time point t0, the voltage VI received by the pulse generator 142 is maintained at 0V (the input power PI is zero), and the pulse generator 142 does not generate the first pulse signal PLS1. Therefore, a voltage level of the control end of the switch SW is maintained at a voltage level of the grounding end GND (e.g., the logic low level) through the second resistor R2. At this time, the switch SW is in an off state, such that a voltage level of the reset pulse signal RPLS is maintained at a voltage level of the voltage VM of the first power PM (which is the logic high level) through the third resistor R3.

Next, at the time point t0, the voltage VI received by the pulse generator 142 rises from 0V to 5V. Accordingly, the pulse generator 142 generates the first pulse signal PLS1 which is a positive pulse. In one embodiment of the invention, the positive pulse width of the first pulse signal PLS1 could be between 140 ms and 560 ms, for example, but is not limited hereto and shall be determined by the actual application or the design needs. The first pulse signal PLS1 could be divided by a divider circuit consisting of the first resistor R1 and the second resistor R2 into a dividing signal for charging the capacitor C1. When a cross voltage of two ends of the capacitor C1 (i.e., a voltage at the node ND) rises and is greater than a threshold voltage of the switch SW, the switch SW is turned on, which causes the voltage level of the reset pulse signal RPLS to become the voltage level of the grounding end GND (e.g., the logic low level) through the switch SW.

When the first pulse signal PLS1 which is the positive pulse ends, the capacitor C1 would be discharged through the second resistor R2. When the cross voltage of the two ends of the capacitor C1 (i.e., the voltage at the node ND) is lowered to below the threshold voltage of the switch SW, the switch SW is turned off, which causes the voltage level of the reset pulse signal RPLS to become the voltage VM of the first power PM (which is at the logic high level) again through the third resistor R3, as shown by the time point t1.

It shall be understood that a time constant of an RC circuit consisting of the second resistor R2 and the capacitor C1 is the pulse width of the reset pulse signal RLS (i.e., the predetermined time period TP). In other words, a resistance of the second resistor R2 and a capacitance of the capacitor C1 may be used to determine the pulse width of the reset pulse signal RPLS. Therefore, in one embodiment of the invention, the second resistor R2 could be a variable resistor, or the capacitor C1 could be a variable capacitor. Accordingly, the designers can modulate the pulse width of the reset pulse signal RPLS by adjusting the resistance of the second resistor R2 or the capacitance of the capacitor C1, such that the purpose of adjusting the time length of disablement of the output voltage signal VO could be achieved in order to meet the actual requirement of different electronic apparatus bodies.

In summary of the above, the power supply circuit of the electronic apparatus provided in the embodiments of the invention is capable of disabling the output voltage signal for a predetermined time period in response to the start of supply of the input power (or in response to the power-on transition from the input power being unavailable to the input power being available), such that the electronic apparatus body could be reset in response to the disable state of the output voltage signal. Accordingly, in the case where an electronic apparatus is not provided with a physical power switch button or a physical reset button, even if the electronic apparatus breaks down or needs to be re-started with the built-in battery still having power, the power supply circuit can reset the electronic apparatus once the input power is re-provided to the electronic apparatus.

Although the invention is disclosed in the embodiments above, the embodiments are not meant to limit the invention. Any person skilled in the art may make slight modifications and variations without departing from the scope of the invention. Therefore, the protection scope of the invention shall be defined by the claims attached below.

## Claims

1. A power supply circuit (100) comprising:
a power input port (PIE1) configured to receive an input power from an external power source apparatus (900);
a battery module (130);
a first power circuit (110) coupled to the power input port (PIE1) and the battery module, wherein the first power circuit is configured to convert the input power and accordingly configured to generate a first power and to output the first power to a second power circuit (120) and to the battery module to charge the battery module (130);
the second power circuit (120) coupled to the first power circuit and the battery module, and is configured to generate an output voltage signal according to the first power,
wherein when the input power is not provided by the external power source apparatus, the first power circuit stops providing the first power to the battery module and the second power circuit (120), and the battery module provides a stored power to serve as the first power to the second power circuit, and
a reset circuit (140), coupled to the power input port (PIE1) and the second power circuit (120), and configured to generate a reset pulse signal in response to a start of supply of the input power when the external power source apparatus is plugged to the power input port (PIE1),
wherein the second power circuit (120) is configured to disable the output voltage signal for a predetermined time period in response to the reset pulse signal received from the reset circuit (140).

2. The power supply circuit (100) according to claim 1, wherein the reset circuit (140) comprises:
a pulse generator (142), an input end of the pulse generator (142) is coupled to the power input port (PIE1) to receive the input power and accordingly generate a first pulse signal (PLS1); and
a pulse width modulation circuit (144) coupled to an output end of the pulse generator (142) to receive the first pulse signal (PLS1) and modulate a pulse width of the first pulse signal (PLS1) and accordingly generate the reset pulse signal (RPLS).

3. The power supply circuit (100) according to claim 2, wherein the pulse width modulation circuit (144) comprises:
a first resistor (R1), having a first end and a second end, the first end of the first resistor (R1) connected to the output end of the pulse generator (142), and the second end of the first resistor (R1) connected to a node (ND);
a second resistor (R2), having a first end and a second end, the first end of the second resistor (R2) connected to a grounding end (GND), and the second end of the second resistor (R2) connected to the node;
a capacitor (C1), having a first end and a second end, the first end of the capacitor (C1) connected to the grounding end (GND), and the second end of the capacitor (C1) connected to the node;
a switch (SW), a first end of the switch being coupled to the grounding end, a control end of the switch (SW) being coupled to the node, and a second end of the switch (SW) generating the reset pulse signal (RPLS); and
a third resistor (R3), a first end of the third resistor (R3) receiving the first power and a second end of the third resistor (R3) being coupled to the second end of the switch.

4. The power supply circuit (100) according to claim 3, wherein a resistance of the second resistor and a capacitance of the capacitor determine the pulse width of the reset pulse signal.

5. The power supply circuit (100) according to claim 4, wherein the pulse width of the reset pulse signal is between 140 ms and 560 ms.

6. The power supply circuit (100) according to one of the claims 3-5, wherein the switch is an NPN bipolar junction transistor or an N-type metal-oxide-semiconductor field-effect transistor.

7. The power supply circuit (100) according to one of the preceding claims, wherein the first power circuit is a battery charger IC.

8. The power supply circuit (100) according to one of the preceding claims, wherein the second power circuit is a low dropout regulator.

9. An electronic apparatus (10) comprising:
an electronic apparatus body (200); and
the power supply circuit (100) according to claim 1, which is coupled to a power input end of the electronic apparatus body, wherein the power supply circuit is configured to provide the output voltage signal to the power input end of the electronic apparatus body to supply power to the electronic apparatus body,
wherein the electronic apparatus body is reset in response to a disable state of the output voltage signal and wherein the output voltage signal is in the disable state for a predetermined time period.

10. The electronic apparatus (10) according to claim 9, wherein the electronic apparatus is not provided with a power button or a reset button.

## Patentansprüche

1. Stromversorgungsschaltkreis (100) umfassend:
einen Leistungseingangsanschluss (PIE1), der konfiguriert ist, um eine Eingangsleistung von einer externen Leistungsquellenvorrichtung (900) zu empfangen;
ein Batteriemodul (130);
einen ersten Leistungsschaltkreis (110), der mit dem Leistungseingangsanschluss (PIE1) und dem Batteriemodul verbunden ist, wobei der erste Leistungsschaltkreis konfiguriert ist, um die Eingangsleistung umzuwandeln, und entsprechend konfiguriert ist, um eine erste Leistung zu erzeugen und die erste Leistung an einen zweiten Leistungsschaltkreis (120) und an das Batteriemodul auszugeben, um das Batteriemodul (130) zu laden;
wobei der zweite Leistungsschaltkreis (120) mit der ersten Leistungsschaltkreis und dem Batteriemodul verbunden ist und konfiguriert ist, um ein Ausgangsspannungssignal gemäß der ersten Leistung zu erzeugen,
wobei, wenn die Eingangsleistung nicht von der externen Leistungsquellenvorrichtung bereitgestellt wird, der erste Leistungsschaltkreis die Bereitstellung der ersten Leistung an das Batteriemodul und den zweiten Leistungsschaltkreis (120) stoppt und das Batteriemodul eine gespeicherte Leistung bereitstellt, die als die erste Leistung für den zweiten Leistungsschaltkreis dient, und
einen Rücksetzschaltkreis (140), der mit dem Leistungseingangsanschluss (PIE1) und dem zweiten Leistungsschaltkreis (120) verbunden und konfiguriert ist, um ein Rücksetzimpulssignal als Reaktion auf den Beginn der Versorgung der Eingangsleistung zu erzeugen, wenn die externe Leistungsquellenvorrichtung an den Leistungseingangsanschluss (PIE1) angeschlossen ist,
wobei der zweite Leistungsschaltkreis (120) konfiguriert ist, um das Ausgangsspannungssignal für eine vorbestimmte Zeitdauer in Reaktion auf das von dem Rücksetzschaltkreis (140) empfangene Rücksetzimpulssignal zu deaktivieren.

2. Stromversorgungsschaltkreis (100) nach Anspruch 1, wobei der Rücksetzschaltkreis (140) umfasst:
einen Impulsgenerator (142), wobei ein Eingangsende des Impulsgenerators (142) mit dem Leistungseingangsanschluss (PIE1) verbunden ist, um die Eingangsleistung zu empfangen und entsprechend ein erstes Impulssignal (PLS1) zu erzeugen; und
einen Impulsbreitenmodulationsschaltkreis (144), der mit einem Ausgangsende des Impulsgenerators (142) verbunden ist, um das erste Impulssignal (PLS1) zu empfangen und eine Impulsbreite des ersten Impulssignals (PLS1) zu modulieren und entsprechend das Rücksetzimpulssignal (RPLS) zu erzeugen.

3. Stromversorgungsschaltkreis (100) nach Anspruch 2, wobei der Impulsbreitenmodulationsschaltkreis (144) umfasst:
einen ersten Widerstand (R1) mit einem ersten Ende und einem zweiten Ende, wobei das erste Ende des ersten Widerstandes (R1) mit dem Ausgangsende des Impulsgenerators (142) verbunden ist und das zweite Ende des ersten Widerstandes (R1) mit einem Knoten (ND) verbunden ist;
einen zweiten Widerstand (R2) mit einem ersten Ende und einem zweiten Ende, wobei das erste Ende des zweiten Widerstandes (R2) mit einem Erdungsende (GND) verbunden ist und das zweite Ende des zweiten Widerstandes (R2) mit dem Knoten verbunden ist;
einen Kondensator (C1) mit einem ersten Ende und einem zweiten Ende, wobei das erste Ende des Kondensators (C1) mit dem Erdungsende (GND) verbunden ist und das zweite Ende des Kondensators (C1) mit dem Knoten verbunden ist;
einen Schalter (SW), wobei ein erstes Ende des Schalters mit dem Erdungsende verbunden ist, ein Steuerende des Schalters (SW) mit dem Knoten verbunden ist und ein zweites Ende des Schalters (SW) das Rücksetzimpulssignal (RPLS) erzeugt; und
einen dritten Widerstand (R3), wobei ein erstes Ende des dritten Widerstandes (R3) die erste Leistung empfängt und ein zweites Ende des dritten Widerstandes (R3) mit dem zweiten Ende des Schalters verbunden ist.

4. Stromversorgungsschaltkreis (100) nach Anspruch 3, wobei ein Widerstandswert des zweiten Widerstandes und ein Kapazitätswert des Kondensators die Impulsbreite des Rücksetzimpulssignals bestimmen.

5. Stromversorgungsschaltkreis (100) nach Anspruch 4, wobei die Impulsbreite des Rücksetzimpulssignals zwischen 140 ms und 560 ms liegt.

6. Stromversorgungsschaltkreis (100) nach einem der Ansprüche 3-5, wobei der Schalter ein bipolarer NPN-Übergangstransistor oder ein Metalloxid-Halbleiter-Feldeffekttransistor vom N-Typ ist.

7. Stromversorgungsschaltkreis (100) nach einem der vorhergehenden Ansprüche, wobei die erste Leistungsschaltkreis ein Batterielade-IC ist.

8. Stromversorgungsschaltkreis (100) nach einem der vorhergehenden Ansprüche, wobei die zweite Leistungsschaltkreis ein Low-Dropout-Regler ist.

9. Elektronische Vorrichtung (10), umfassend:
ein für die elektronische Vorrichtung vorgesehenes Gehäuse (200); und
den Stromversorgungsschaltkreis (100) nach Anspruch 1, der mit einem Leistungseingangsende des für die elektronische Vorrichtung vorgesehenen Gehäuses (200)verbunden ist, wobei die Stromversorgungsschaltkreis konfiguriert ist, das Ausgangsspannungssignal für das Leistungseingangsende des für die elektronische Vorrichtung vorgesehenen Gehäuses (200) bereitzustellen, um das für die elektronische Vorrichtung vorgesehene Gehäuse mit Leistung bzw. Strom zu versorgen,
wobei das für die elektronische Vorrichtung vorgesehene Gehäuse als Reaktion auf einen Sperrzustand des Ausgangsspannungssignals zurückgesetzt wird und wobei sich das Ausgangsspannungssignal für eine vorbestimmte Zeitdauer im Sperrzustand befindet.

10. Elektronische Vorrichtung (10) nach Anspruch 9, wobei die elektronische Vorrichtung nicht mit einem Einschaltknopf oder einem Rückstellknopf versehen ist.

## Revendications

1. Un circuit d'alimentation électrique (100) comprenant:
une borne d'entrée d'alimentation (PIE1) configurée pour recevoir l'alimentation d'un dispositif de source d'alimentation externe (900) ;
un module de batterie (130) ;
un premier circuit d'alimentation (110) couplé à la borne d'entrée d'alimentation (PIE1) et au module de batterie, le premier circuit d'alimentation étant configuré pour convertir l'alimentation d'entrée et configuré pour générer une première alimentation et pour fournir la première alimentation à un deuxième circuit d'alimentation (120) et au module de batterie pour charger le module de batterie (130) ;
dans lequel le deuxième circuit d'alimentation (120) est connecté au premier circuit d'alimentation et au module de batterie et est configuré pour générer un signal de tension de sortie en fonction de la première alimentation,
dans lequel, si l'alimentation d'entrée n'est pas fournie par le dispositif de source d'alimentation externe, le premier circuit d'alimentation cesse de fournir la première alimentation au module de batterie et le second circuit d'alimentation (120) et le module de batterie fournit l'alimentation stockée qui sert de première alimentation au second circuit d'alimentation; et
un circuit de réinitialisation (140) connecté à la borne d'entrée d'alimentation (PIE1) et au deuxième circuit d'alimentation (120) et configuré pour générer un signal d'impulsion de réinitialisation en réponse au début de l'alimentation de l'entrée lorsque le dispositif de source d'alimentation externe est connecté à la borne d'entrée d'alimentation (PIE1),
dans lequel le second circuit d'alimentation (120) est configuré pour désactiver le signal de tension de sortie pendant une période de temps prédéterminée en réponse au signal d'impulsion de réinitialisation reçu du circuit de réinitialisation (140).

2. Le circuit d'alimentation (100) selon la revendication 1, dans lequel le circuit de réinitialisation (140) comprend:
un générateur d'impulsions (142), une extrémité d'entrée du générateur d'impulsions (142) est couplée au port d'entrée de alimentation (PIE1) pour recevoir l'alimentation d'entrée et générer en conséquence un premier signal d'impulsion (PLS1); et
un circuit de modulation de largeur d'impulsion (144) couplé à une extrémité de sortie du générateur d'impulsions (142) pour recevoir le premier signal d'impulsion (PLS1) et moduler une largeur d'impulsion du premier signal d'impulsion (PLS1) et générer en conséquence le signal d'impulsion de réinitialisation (RPLS).

3. Le circuit d'alimentation électrique (100) selon la revendication 2, dans lequel le circuit de modulation de largeur d'impulsion (144) comprend:
une première résistance (R1), ayant une première extrémité et une seconde extrémité, la première extrémité de la première résistance (R1) étant connectée à l'extrémité de sortie du générateur d'impulsions (142), et la seconde extrémité de la première résistance (R1) étant connectée à un noeud (ND) ;
une seconde résistance (R2), ayant une première extrémité et une seconde extrémité, la première extrémité de la seconde résistance (R2) étant connectée à une extrémité de mise à la terre (GND) et la seconde extrémité de la seconde résistance (R2) étant connectée au noeud ;
un condensateur (C1), ayant une première extrémité et une seconde extrémité, la première extrémité du condensateur (C1) étant connectée à l'extrémité de mise à la terre (GND) et la seconde extrémité du condensateur (C1) étant connectée au noeud ;
un commutateur (SW), une première extrémité du commutateur étant couplée à l'extrémité de mise à la terre, une extrémité de commande du commutateur (SW) étant couplée au noeud, et une seconde extrémité du commutateur (SW) générant le signal d'impulsion de réinitialisation (RPLS); et
une troisième résistance (R3), une première extrémité de la troisième résistance (R3) recevant la première alimentation et une seconde extrémité de la troisième résistance (R3) étant couplée à la seconde extrémité du commutateur.

4. Le circuit d'alimentation (100) selon la revendication 3, dans lequel une résistance de la deuxième résistance et une capacité du condensateur déterminent la largeur d'impulsion du signal d'impulsion de réinitialisation.

5. Le circuit d'alimentation (100) selon la revendication 4, dans lequel la largeur d'impulsion du signal d'impulsion de réinitialisation est comprise entre 140 ms et 560 ms.

6. Le circuit d'alimentation (100) selon l'une des revendications 3-5, dans lequel le commutateur est un transistor à jonction bipolaire NPN ou un transistor à effet de champ métal-oxyde-semiconducteur de type N.

7. Le circuit d'alimentation (100) selon l'une des revendications précédentes, dans lequel le premier circuit d'alimentation est un circuit intégré de chargeur de batterie.

8. Le circuit d'alimentation (100) selon l'une des revendications précédentes, dans lequel le second circuit d'alimentation est un régulateur à faible perte de charge.

9. Un appareil électronique (10) comprenant :
un corps d'appareil électronique (200); et
le circuit d'alimentation électrique (100) selon la revendication 1, qui est couplé à une extrémité d'entrée de alimentation du corps de l'appareil électronique, dans lequel le circuit d'alimentation électrique est configuré pour fournir le signal de tension de sortie à l'extrémité d'entrée de alimentation du corps de l'appareil électronique pour alimenter le corps de l'appareil électronique,
dans lequel le corps de l'appareil électronique est réinitialisé en réponse à un état de désactivation du signal de tension de sortie et dans lequel le signal de tension de sortie est à l'état de désactivation pendant une période de temps prédéterminée.

10. Appareil électronique (10) selon la revendication 9, dans lequel l'appareil électronique n'est pas pourvu d'un bouton de mise en marche ou d'un bouton de réinitialisation.
